Europäisches Patentamt

European Patent Office

Office européen des brevets

(11) Numéro de publication: **0 048 782**
**B1**

(12) **FASCICULE DE BREVET EUROPEEN**

(45) Date de publication du fascicule du brevet: **02.05.85**

(21) Numéro de dépôt: **80430019.2**

(22) Date de dépôt: **26.09.80**

(51) Int. Cl.⁴: **G 11 C 11/40,** G 11 C 11/24, G 11 C 17/00

(54) Circuit de décodage et de sélection pour une mémoire monolithique.

(43) Date de publication de la demande:
**07.04.82 Bulletin 82/14**

(45) Mention de la délivrance du brevet:
**02.05.85 Bulletin 85/18**

(84) Etats contractants désignés:
**DE FR GB**

(56) Documents cités:
**IBM TECHNICAL DISCLOSURE BULLETIN, vol. 20, no. 11A, avril 1978, NEW YORK (US), V. MARCELLO et al.: "Decode circuit with up-level clamp", pages 4406-4408
IBM TECHNICAL DISCLOSURE BULLETIN, vol. 23, no. 4, septembre 1980, NEW YORK (US), G. BOUDON et al.: "Memory power down circuit and word line decoder/driver under low power supply", pages 1475-1476
Valvo Bericht, Band XIX, Heft 3, 1974, Seiten 67-132**

(73) Titulaire: **International Business Machines Corporation
Old Orchard Road
Armonk, N.Y. 10504 (US)**
(84) **DE GB**

(73) Titulaire: **Compagnie IBM FRANCE
5 Place Vendôme
F-75000 Paris 1er (FR)**
(84) **FR**

(72) Inventeur: **Boudon, Gérard
5, rue des Coudriers
F-91540 Mennecy (FR)**
Inventeur: **Denis, Bernard
9, rue des MÛres
F-91540 Mennecy (FR)**
Inventeur: **de Grivel, Virginie
9 bis, rue de Rouvray
F-92200 Neuilly (FR)**
Inventeur: **Mollier, Pierre
15, rue de Ponthierry Boissise le Roi
F-77310 Saint Fargeau Ponthierry (FR)**

(74) Mandataire: **Lattard, Nicole
Compagnie IBM France Département de Propriété Industrielle
F-06610 La Gaude (FR)**

Courier Press, Leamington Spa, England.

## Description

### Domaine technique

La présente invention concerne un circuit de décodage et de sélection très performant, adapté à tout type de mémoire monolithique (mémoire morte ROM ou mémoire à accès aléatoire RAM) et un générateur de tension de référence qui lui est destiné.

Dans de nombreux systèmes: calculateurs, microprocesseurs, on utilise de nombreuses mémoires et en conséquence il faut réaliser ces éléments au moindre coût et avec les plus petites dimensions possibles. Un des problèmes qui se pose lorsque la densité d'intégration augmente est celui de la dissipation de puissance.

### Description de l'art antérieur

La demande de brevet européen 79103921.7 publiée sous le numéro EP—A—0 011 700, concerne une mémoire monolithique dans laquelle la dissipation de puissance a été réduite en alimentant les cellules sélectionnées sous une tension plus élevée que la tension d'alimentation des cellules non sélectionnées ce qui est obtenu grâce à des circuits à commutation de courant.

Les circuits de décodage et de sélection tels que décrit dans l'article publié dans "l'IBM Technical Disclosure Bulletin" Vol. 20, No. 11A, d'avril 1978, pages 4406 à 4408, utilisent généralement un transistor d'attaque associé à chaque ligne de mots et un circuit de décodage d'adresse à diodes, le transistor d'attaque étant rendu conducteur lorsque la ligne de mot correspondante est sélectionnée. Une résistance est connectée à la base du transistor et au point commun aux anodes des diodes du décodeur pour fournir le courant de sélection à la base du transistor lorsque la ligne est sélectionnée, toutes les diodes étant bloquées à ce moment. Lorsque la ligne n'est pas sélectionnée, au moins une des diodes du décodeur conduit et le courant dans la résistance est dévié par les diodes conductrices.

Un inconvénient d'un tel circuit est que la résistance est une cause de dissipation importante.

### Résumé de l'invention

En conséquence, un objet de la présente invention est de réaliser un circuit de décodage et de sélection qui permette de réduire la dissipation de puissance dans une mémoire monolithique à grande densité d'intégration.

Un autre objet de la présente invention est de réaliser un circuit de décodage et de sélection qui ne nécessite qu'une faible tension d'alimentation.

Un autre objet de la présente invention est de réaliser un circuit de décodage et de sélection qui permette d'obtenir une sélection rapide.

Un autre objet de la présente invention est de réaliser un générateur de tension de référence qui permette de maintenir constant le courant de base due transistor d'attaque à une valeur minimum.

Le circuit de décodage et de sélection conforme à l'invention est destiné à un ensemble de mémoire du type comprenant une matrice de cellules disposées en n rangées et m colonnes, les cellules des différentes rangées étant connectées à n lignes de mot, la sélection d'une ligne de mot étant réalisée sous contrôle d'un circuit de décodage d'adresse recevant en entrée un signal pour l'adressage d'une ligne et ayant n sorties, chaque sortie commandant l'état d'un transistor d'attaque de ligne. Les n transistors d'attaque sont d'un premier type de conductivité par exemple NPN et ont une de leur électrode de conduction par exemple le collecteur, connectée à une première tension d'alimentation, l'autre électrode de conduction est connectée à une ligne de mot et l'électrode de commande est connectée à une sortie du circuit de décodage.

Le circuit comprend n transistors de contrôle de conductivité opposée à celle des transistors d'attaque chacun desdits transistors étant associé à un transistor d'attaque et ayant une première électrode de conduction connectée à la tension d'alimentation et la seconde électrode connectée à l'électrode de commande du transistor d'attaque associé. Les transistors de contrôle sont groupés en k groupes de p éléments avec k.p=m, les électrodes de commande des transistors d'un groupe étant connectées ensemble.

Des moyens sont prévus pour maintenir dans les transistors de contrôle un courant constant minimum.

Ces moyens comprennent k transistors de régulation de même type de conductivité que les transistors de contrôle, chacun des transistors de régulation qui est monté en miroir de courant avec les p transistors de contrôle de chacun des groupes, a son électrode de commande connectée aux électrodes de commande des transistors de contrôle, une première électrode de conduction connectée à la première tension d'alimentation et la seconde électrode de conduction connectée à l'électrode de commande et à une source de courant contrôlable.

La source de courant contrôlable comprend:

un transistor dont une électrode de conduction est connectée au collecteur du transistor de régulation, l'autre électrode de conduction est connectée par une résistance à une seconde tension d'alimentation, et

un générateur de tension de référence, connecté à l'électrode de commande dudit transistor source de courant, comprenant: deux transistors de même type et de même caractéristique que les transistors de contrôle et montés en miroir de courant, le premier ayant son électrode de commande et une première électrode de conduction connectées en commun et reliées par une première résistance à la seconde tension d'alimentation, et la seconde électrode de conduction connectée à la première tension d'alimentation et le second ayant son électrode de commande connectée à l'électrode de commande du premier, la première électrode de conduction connectée par une seconde résistance de même valeur que la première à la seconde

tension d'alimentation, et la seconde électrode de conduction connectée à la première tension d'alimentation, et

un circuit de sortie pour générer à partir de la tension à la première électrode de conduction dudit second transistor, la tension de référence.

D'autres objets et avantages de la présente invention ressortiront mieux de l'exposé qui suit, fait en référence aux dessins annexés à ce texte, qui représentent un mode de réalisation préféré de celle-ci.

Brève description des figures

La figure 1 représente la disposition du circuit de sélection conformément à la présente invention.

La figure 2 représente un circuit de décodage d'adresse qui peut être utilisé pour commander le circuit de sélection de la figure 1.

La figure 3 représente le schéma d'une cellule de mémoire qui peut être incorporée dans l'arrangement de la figure 1.

La figure 4 représente le schéma d'un générateur de tension de référence pour fournir la tension REF de la figure 1.

Description détaillée de l'invention

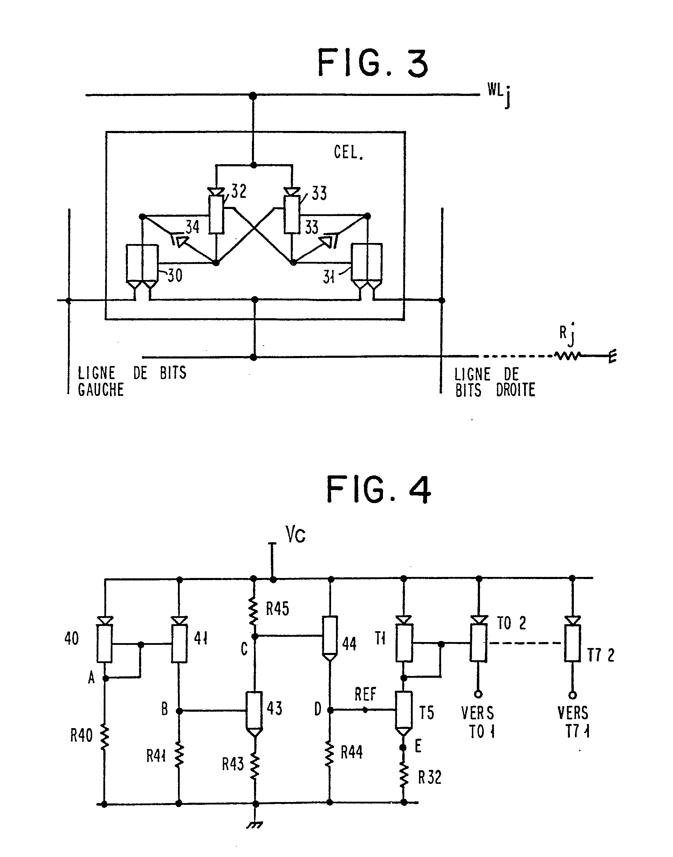

L'arrangement conforme à l'invention est utilisée pour sélectionner une ligne de mot WL0 à WLn dans une mémoire comportant une matrice de cellule CEL disposées en rangées et colonnes. Sur le dessin on n'a représenté que les lignes WL0, WL7, WL24 et WL31 dans un but de clarté. Les cellules CEL peuvent être d'un type quelconque, par exemple des cellules de Harper classiques ou des cellules de Harper à PNP tel que représenté sur la figure 3. Ces cellules sont connectées à une ligne de mot, WLj et à des lignes de bits qui ne sont pas représentées sur la figure, car elles n'interviennent pas pour la sélection d'une rangée de cellules. Les cellules sont d'autre part connectées à la masse par l'intermédiaire de résistance R0 à R31. La sélection d'une ligne de mot se fait en augmentant le potentiel sur la ligne à sélectionner.

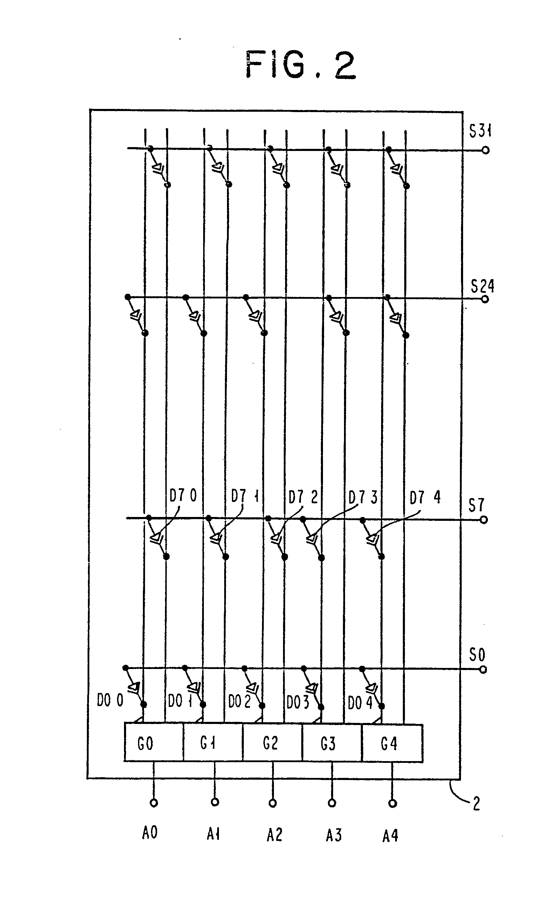

La sélection est réalisée par l'intermédiaire du circuit de sélection 1, commandé par un circuit de décodage d'adresses 2 représenté sur la figure 2.

Comme on peut le voir sur la figure 2 les signaux binaires d'adresses A0 à A4 sont appliqués à des générateurs valeurs vraies/complémentaires G0 à G4. Chaque générateur fournit sur une de ses sorties la valeur du signal à l'entrée et sur son autre sortie référencée par le signe Δ, le complément du signal d'entrée. Le décodage des signaux d'adresse se fait par l'intermédiaire de diodes de Schottky qui sont disposées en matrice, la cathode d'une diode étant connectée à une des sorties vraie ou complémentaire d'un générateur, et l'anode de la diode étant connectée à une ligne horizontale S0 à S31.

Par exemple les diodes D0 0, D0 1, D0 2, D0 3 et D0 4 ont leurs cathodes connectées aux sorties complémentaires des générateurs G0 à G4. De cette façon lorsque le signal d'adresse 00000 est appliqué sur les entrées A0 à A4, les diodes D0 0 à D0 4 sont bloquées. Les diodes connectées aux différentes lignes S sont disposées pour qu'elles soient bloquées lorsque le signal d'adresse correspondant est appliqué aux entrées A0 à A4. Avec cinq digits d'adresse on peut sélectionner 32 lignes 0 à 31, si la mémoire comporte plus de lignes de mot il faut ajouter des digits d'adresse.

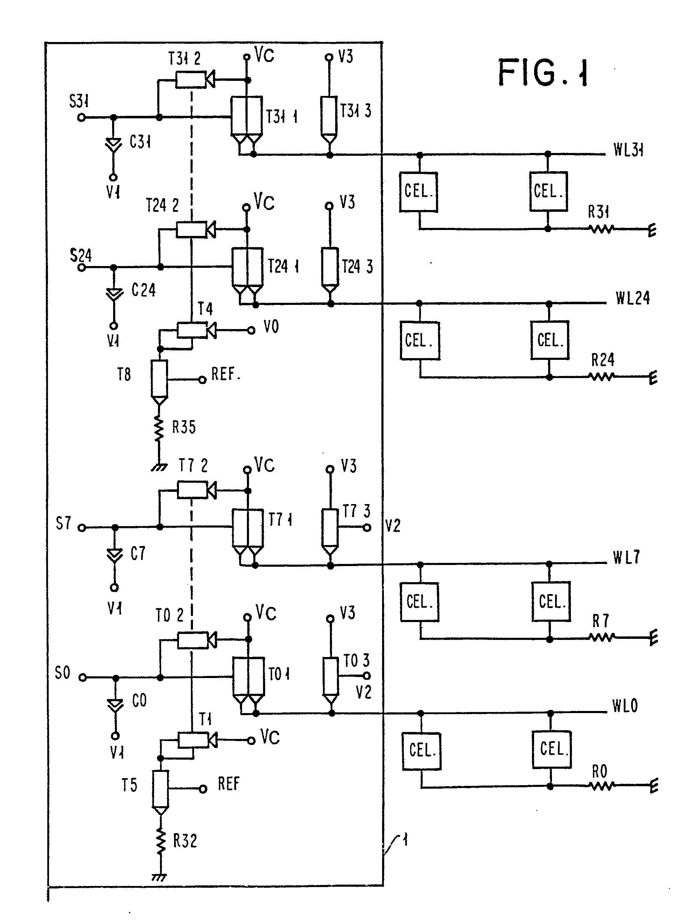

Les lignes S0 à S31 sont appliquées aux entrées du circuit de sélection 1 (figure 1). Les éléments du circuit de sélection correspondant à la sélection d'une ligne de mot WLj sont référencés par une lettre suivie du suffixe j et d'un numéro de référence.

Des diodes de Schottky de blocage C0 à C31 ont leur anode connectée aux lignes S0 à S31 et leur cathode connectée à une tension d'alimentation V1 égale à 2,2 volts.

Le circuit de sélection de la ligne WL0 comporte un transistor d'attaque NPN T0 1 à double émetteur dont la base est connectée à la ligne de sélection S0, le collecteur connecté à une alimentation de tension Vc qui dans le mode de réalisation préféré de l'invention est égale à 3,4 volts, et les émetteurs sont connectés à la ligne de mot WL0.

Un transistor PNP de controle T0 2 a son émetteur connecté au collecteur du transistor T0 1 et son collecteur connecté à la base du transistor T0 1. Le transistor T0 2 est monté en miroir de courant avec un transistor PNP de régulation T1, c'est-à-dire, il a sa base connectée à la base du transistor T1. La base et le collecteur du transistor T1 sont connectés ensemble, et son émetteur est connecté à la tension Vc. Une source de courant, transistor T5 et une résistance R32 est connectée au transistor T1. Le collecteur du transistor T5 est connecté au collecteur du transistor T1, son émetteur connecté à une borne de la résistance R32 dont l'autre borne est connectée à la masse. La base du transistor T5 est connectée à une tension de référence qui est fournie par un générateur dont une description sera donnée en référence à la figure 4.

Huit transistors T0 2, T1 2 à T7 2 ont leurs bases connectées ensemble à la base du transistor T1. Dans une mémoire à 32 lignes de mot, il y a donc quatre groupes de transistors, T0 2 à T7 2, T8 2 à T15 2, T16 2 à T23 2, T24 2 à T31 2 et en conséquence il y a quatre circuits T1, T5, R32 à T4, T8, R35. Il est bien évident que ces nombres ne sont donnés qu'à titre d'exemple et qu'en fonction des réalisations possibles d'autres nombres peuvent être choisis.

Un transistor supplémentaire T0 3 est monté en commutateur de courant avec le transistor T0 1. Les émetteurs des transistors T0 3 et T0 1 sont connecté ensemble, la base du transistor T0 3 est connectée à une tension de référence V2, et son collecteur est connecté à une tension d'alimentation réduite V3. Dans un mode de réalisation préféré, la tension V2 est choisie égale à 1,9 volt et la tension V3 est choisie égale à 1,7 volt. Ce transistor alimente la ligne de mot lorsqu'elle n'est pas sélectionnée conformément à la disposition décrite dans la demande de brevet européen citée au début de la description.

Le fonctionnement du circuit des figures 1 et 2 est le suivant.

En supposant que l'on désire sélectionner la ligne de mot WL0, les digits d'adresse 00000 sont appliqués aux entrées A0 à A4. Les diodes D0 0 à D0 4 sont donc bloquées, et dans toutes les autres rangées de diodes de la matrice de décodage au moins une diode est conductrice.

En conséquence, le courant collecteur Ic du transistor T0 2 est appliqué à la base du transistor T0 1 rendant celui-ci conducteur. De ce fait le transistor T0 3 qui était conducteur quand la ligne n'était pas sélectionnée est bloqué et la tension sur la ligne de mot augmente et passe de 1,2 volt à 2,0 volts, provoquant la sélection de la ligne de mot.

Le transistor T1 associé à la source de courant T5 permet de réguler le courant collecteur Ic dans le transistor T0 2 si bien qu'il devient indépendant des variations de la tension d'alimentation Vc.

Les transistors T1 à T0 2 sont des transistors PNP latéraux et leur facteur β fait que le courant de commande est β fois moins grand que le courant Ic régulé permettant la diminution de puissance.

Dans les autres lignes non sélectionnées au moins une des diodes de Schottky de la matrice de décodage est conductrice, par exemple pour la ligne WL7, les diodes D7 0, à D7 4 sont conductrices, en conséquence le courant collecteur du transistor T7 2 passe dans ces diodes laissant le transistor T7 1 bloqué. Il en est de même pour toutes les autres lignes.

Sur la figure 3 est représenté le schéma d'une cellule qui peut être utilisée avec les circuits de décodage et de sélection tel que représenté sur les figures 1 et 2, étant bien entendu que le principe de la présente invention peut s'appliquer à n'importe quel type de cellules constituant une mémoire à accès aléatoire ou une mémoire morte. On pourra se référer à la publication IBM Technical Disclosure Bulletin, Vol. 16, No. 12, mai 1974, pages 3931-33, dans laquelle une telle cellule est décrite.

La cellule comporte deux transistors à émetteurs couplés 30 et 31 de la même façon qu'une cellule de Harper classique. Des transistors PNP 32 et 33 sont disposés comme charges à la place des résistances de la cellule classique. Les émetteurs des transistors 32 et 33 sont connectés à la ligne de mot et les émetteurs couplés des transistors 30 et 31 sont connectés à la masse par la résistance Rj. L'autre émetteur du transistor 30 est connecté à la ligne de bits gauche et l'autre émetteur du transistor 31 est connecté à la ligne de bits droite. Deux diodes de Schottky 34 et 35 sont associés aux transistors 30, 32 et 31, 33, respectivement.

L'anode de la diode 34 est connectée à la base du transistor 30 et au collecteur du transistor 32 et sa cathode est connectée à la base du transistor 32 et au collecteur du transistor 30. La disposition de la diode 35 et des transistors 31 et 33 est identique.

La cellule se comporte comme une bascule, dans laquelle l'information binaire à mémoriser 1 ou 0 est représentée par l'état des transistors 30 et 31.

On va maintenant décrire en référence à la figure 4 un générateur de tension qui peut être utilisé pour fournir la tension REF sur la base des transistors T5 à T8. Dans un ensemble de mémoires à 32 lignes de mot, il faudra quatre circuits générateurs identiques.

Sur la figure 4, on a représenté le circuit associé avec le transistor T5 et donc utilisé pour réguler les courants collecteurs Ic des transistors T0 2 à T7 2 montés en parallèle sur le transistor T1.

La régulation est effectuée en modulant le courant collecteur Ic du transistor T1 en fonction du facteur gain β des transistors PNP.

Le circuit comprend deux transistors 40 et 41 associés à deux résistances de même valeur R40 et R41. Les transistors 40 et 41 sont montés en miroir de courant, leurs émetteurs étant reliés à la tension Vc, leurs bases étant connectées en commun, la base du transistor 40 étant connectée à son collecteur. Les collecteurs des transistors 40 et 41 sont reliés par les résistances R40 et R41 à la masse. Du fait de ce montage, ils sont parcourus par le même courant collecteur que les transistors T1, T0 2 à T7 2, si l'on choisi R40=R41=7kΩ.

Au noeud B qui est le point commun entre le collecteur du transistor 41 et de la résistance R41 est générée une tension fonction du facteur β des transistors PNP qui est utilisée pour réguler le courant collecteur Ic à travers les transistors 43, 44, T5 et T1.

Le transistor 43 a sa base connectée au noeud B, son émetteur connecté à la masse par une résistance R43 et son collecteur connecté à la tension Vc par une résistance R45. Le noeud C au collecteur du transistor 43 est connecté à la base du transistor 44. Le collecteur du transistor 44 est connecté à la tension Vc, son émetteur (noeud D) est connecté à la masse par une résistance R44. La tension de référence REF est prise au noeud D.

Le courant à réguler IR32 dans la résistance R32 est égal à

$$IR32=(1+9/\beta)Ic \qquad (1)$$

β étant le facteur gain des neuf transistors PNP T1, T0 2 à T7 2 et Ic le courant collecteur de T1.

Si l'on suppose que le courant à réguler Ic vaut 0,35mA le courant IR32 devra varier pour compenser exactement le facteur β des transistors PNP suivant la formule (1) tel que:

| β | 3 | 9 | 18 |
|------|--------|--------|----------|
| IR32 | 1,4 mA | 0,7 mA | 0,525 mA |

Les courants collecteurs des transistors 40 et 41 qui ont leurs émetteurs et bases communs, sont égaux et sont choisis égaux au courant Ic fixant R40=R41=7kΩ.

On va maintenant calculer la variation de la tension $V_B$ au noeud B.

$$IR40 = \frac{Vc - V_{BE}}{R40} = Ic(40)(1 + 2/\beta)$$

où $V_{BE}$ est la tension base émetteur d'un transistor.

$$V_B = R41 \times Ic(40) = \frac{R41}{R40}\left(\frac{Vc - V_{BE}}{1 + 2/\beta}\right) \quad (2)$$

En prenant $V_{BE} = 0,75$ volt, et $Vc = 3,4$ volts on peut en déduire la variation suivante de $V_B$ en fonction du facteur $\beta$.

| $\beta$ | 3 | 9 | 18 |
|---------|------|------|-------|
| $V_B$ | 1,59 | 2,17 | 2,385 |

On peut voir que la tension au noeud B est proportionnelle au facteur $\beta$ des transistors PNP alors que la tension à générer aux bornes de R32 est inversement proportionnelle.

Le circuit constitué par le transistor 43 et les résistances R43 et R45 est utilisé pour inverser la tension en B.

La tension au noeud E aux bornes de la résistance R32 est égale à:

$$V_E = Vc - 2V_{BE} - V_C = Vc - 2V_{BE} - [(V_B - V_{BE})\frac{R45}{R43}]$$

$$V_E = Vc - V_{BE}[2 - \frac{R45}{R43}] - V_B\frac{R45}{R43} \quad (3)$$

Un calcul de courant Ic en utilisant la formule (1) et la formule (3) montre que la dérivée $dIc/d\beta$ est nulle si on choisit le rapport R45/R43 = 0,86. Avec $R32 = 0,84 \, k\Omega$ on obtient le tableau suivant montrant que le courant Ic reste pratiquement constant quelque soit le facteur $\beta$.

| $\beta$ | 3 | 9 | 18 |
|-----------|-------|-------|-------|
| $V_E$ (V) | 1,178 | 0,688 | 0,494 |
| IR32 (mA) | 1,4 | 0,81 | 0,59 |
| Ic (mA) | 0,35 | 0.40 | 0,39 |

Grâce à la disposition du décodeur de la présente invention, on peut réaliser un ensemble de mémoire dans lequel la tension d'alimentation est réduite, égale à 3,4 volts, et dans lequel la puissance dissipée dans le décodeur est égale à 66,7 mW au lieu de 190 mW, puissance qui serait dissipée si on utilisait le circuit classique à résistance.

De plus la vitesse de sélection est accrue du fait de la vitesse de commutation du transistor d'attaque.

Bien que l'on ait décrit dans ce qui précède et représenté sur les dessins les caractéristiques essentielles de l'invention appliquées à un mode de réalisation préféré de celle-ci, il est évident que l'homme de l'art peut y apporter toutes modifications de forme ou de détail qu'il juge utiles, sand pour autant sortir du cadre de ladite invention.

**·Revendications**

1. Circuit de décodage et de sélection (Figure 1) destiné à un ensemble de mémoire du type comprenant une matrice de cellules disposées en n rangées et m colonnes les cellules des différentes rangées étant connectées à n lignes de mot, la sélection d'une ligne de mot étant réalisée sous contrôle d'un circuit de décodage d'adresse recevant en entrée un signal pour l'adressage d'une ligne, et ayant n sorties ($S_0$—$S_{31}$), chaque sortie commandant l'état d'un transistor d'attaque de ligne (T0 1—T31 1), les n transistors d'attaque étant d'un premier type de conductivite (NPN) et ayant une de leur électrode de conduction (collecteur) connectée à une première tension d'alimentation (Vc), l'autre électrode de conduction (émetteur) connectée à une ligne de mot (WL) et l'électrode de commande (base) connectée à une sortie du circuit de décodage et caractérisé en ce qu'il comprend:

n transistors de contrôle (T0 2—T31 2) ayant une conductivité (PNP) opposée à celle des transistors d'attaque, chacun desdits transistors étant associé à un transistor d'attaque, et ayant une première électrode de conduction (emetteur) connectée à la tension d'alimentation (Vc) et la seconde électrode de conduction (collecteur) connectée à l'électrode de commande du transistor d'attaque associé,

lesdits transistors de contrôle sont groupés en k groupes de p éléments avec k.p=m les électrodes de commande des transistors d'un groupe étant connectées ensemble,

des moyens pour maintenir dans les transistors de contrôle un courant constant minimum, lesdits moyens comprenant:

k transistors de régulation (T1—T4) de même type de conductivité (PNP) que les transistors de contrôle chacun des transistors de régulation monté en miroir de courant avec les p transistors de contrôle de chacun des groupes, a son électrode de commande (base) connectée aux électrodes de commande des transistors de contrôle, une première électrode de conduction (emetteur) connectée à la première tension d'alimentation et la seconde électrode de conduction (collecteur) connectée à l'électrode de commande et à une source de courant contrôlable, comprenant:

un transistor (T5—T8) dont une électrode de conduction (collecteur) est connectée au transistor de régulation, l'autre électrode de conduction (émetteur) est connectée par une résistance à une seconde tension d'alimentation (masse), et

un générateur de tension de référence (Figure 4), connecté à l'électrode de commande dudit transistor source de courant, comprenant:

deux transistors (40, 41) de même type et de même caractéristique que les transistors de contrôle et montés en miroir de courant, le premier (40) ayant son électrode de commande (base) et une première électrode de conduction (collecteur) connectées en commun et reliées par une première résistance (R40) à la seconde tension d'alimentation (masse), et la seconde électrode de conduction (émetteur) connectée à la première tension d'alimentation (Vc) et le second (41) ayant son électrode de commande (base) connectée à l'électrode de commande du premier, la première électrode de conduction (collecteur) connectée par une seconde résistance (R41) de même valeur que la première (R40) à la seconde tension d'alimentation (masse), et la seconde électrode de conduction (émetteur) connectée à la première tension d'alimentation, et

un circuit de sortie (43, 44, R43, R44, R45) pour générer à partir de la tension à la première électrode de conduction (collecteur) dudit second transistor (41), la tension de référence (REF).

2. Circuit selon la revendication 1 caractérisé en ce que le circuit de sortie comprend:

un premier transistor (43) ayant son électrode de commande (base) connectée à la première électrode de conduction (collecteur) du second transistor (41) du miroir de courant du générateur de tension, le première électrode de conduction (collecteur) connectée par une première résistance (R45) a la première tension d'alimentation (Vc) et la seconde électrode de conduction (emetteur) connectée par une seconde résistance (R43) à la seconde tension d'alimentation (masse),

un second transistor (44) ayant son électrode de commande (base) connectée à la première électrode de conduction (collecteur) du premier transistor (43), sa première électrode de conduction (collecteur) connectée à la première tension d'alimentation (Vc) et sa seconde électrode de conduction (émetteur) connectée par une troisième résistance (R44) à la seconde tension d'alimentation, la tension de référence étant générée à la seconde électrode de conduction dudit second transistor (44).

3. Circuit selon la revendication 2, caractérisé en ce que la rapport des valeurs de la première résistance (R45) et de la seconde résistance (R43) du circuit de sortie est voisin de 0,8.

4. Circuit selon la revendication 1, 2 ou 3 caractérisé en ce que les transistors d'attaque sont de type NPN et les transistors de contrôle et de régulation de type PNP.

5. Circuit selon la revendication 4 caractérisé en ce que les collecteurs des transistors d'attaque et les émetteurs des transistors de contrôle et de régulation sont connectés à la première tension d'alimentation, les émetteurs des transistors d'attaque sont connectés aux ligne de mot, les bases desdits transistors sont connectées aux sorties du circuit de décodage d'adresse et aux collecteurs des transistors de contrôle.

6. Circuit selon la revendication 5 caractérisé en ce que chaque transistor source de courant est un transistor de type NPN ayant son collecteur connecté au collecteur du transistor de contrôle, son émetteur connecté par ladite résistance à la seconde tension d'alimentation et sa base connectée au générateur de tension de référence.

7. Circuit selon la revendication 5 ou 6 caractérisé en ce que la première électrode de conduction des premier et second transistors (40, 41) du miroir de courant du générateur de tension est le collecteur, la seconde électrode de conduction et l'émetteur et les électrodes de commande sont les bases.

8. Circuit selon la revendication 7 caractérisé en ce que la première électrode de conduction des premier et second transistors (43, 44) du circuit de sortie est le collecteur, la seconde électrode de conduction est l'émetteur et les électrodes de commande sont les bases.

**Patentansprüche**

1. Dekodier- und Auswahlschaltung (Figur 1) fuer eine Speicherstruktur mit einer Matrix von Zellen, die in n Zeilen und m Spalten angeordnet sind, wobei die Zellen in den einzelnen Zeilen an n Wortlinien gekoppelt sind, wobei die Auswahl einer Wortlinie von einer Adressdekodier-Schaltung gesteuert ist, dessen Eingang ein Signal bezueglich der Dekodierung einer Linie aufnimmt und die n Ausgaenge (S0—S31) aufweist, indem jeder Ausgang den Zustand eines Linientreiber-Transistors (T0 1—T31 1) steuert, wobei die n Treibertransistore ein erstes Typ von Leitfaehigkeit (NPN) haben, und bei dem die eine leitungsfaehige Elektrode (Kollektor) mit einer ersten Spannungsquelle (Vc), die andere leitungsfaehige Elektrode (Emitter) mit einer Wortlinie (WL) und die Steuerelektrode (Basis) mit dem Dekodierschaltung-Ausgang verbunden ist, dadurch gekennzeichnet, dass dieser Dekodier- und Auswahlschaltung folgendes aufweist:

n Kontrolltransistore (T0 2—T31 2) mit einer der den Treibertransistoren entgegengesetzten Leitfaehigkeit (PNP), wobei jeder Kontrolltransistor einem Treibertransistor zugeordnet ist, und in dem eine erste leitungsfaehige Elektrode (Emitter) mit der Spannungsquelle (Vc) und die zweite leitungsfaehige Elektrode (Kollektor) mit der Steuerelektrode des zugeordneten Treibertransistors verbunden ist, wobei die Kontrolltransistore zu k Gruppen von p Elementen (mit k.p=m) zusammengefasst sind, und die Steuerelektrode der zu einer Gruppe gehoerigen Transistore gemeinsam verbunden sind,

Mittel, um einen minimalen konstanten Strom in den Kontrolltransistoren aufrechtzuerhalten, wobei diese Mittel folgendes aufweisen:

K Regeltransistore (T1—T4) des gleichen Typs von Leitfaehigkeit (PNP) wie die Kontrolltransistore, wobei jeder zusammen mit den p Kontrolltransistoren von jeder Gruppe als ein Stromspiegel aufgebaute Regeltransistor seine Steuerelektrode (Basis) mit den Steuerelektroden der Kontrolltransistore, eine erste leitungsfaehige Elektrode (Emitter) mit der ersten Spannungsquelle und die zweite leitungsfaehige Elektrode (Kollektor) mit der Steuerelektrode und mit einer einstellbaren Stromquelle verbunden ist, wobei diese Regeltransistore folgendes aufweisen:

einen Transistor (T5—T8), bei dem eine leitungsfaehige Elektrode (Kollektor) mit dem Regeltransistor und die andere leitungsfaehige Elektrode (Emitter) ueber einen Widerstand mit einer zweiten Spannungsquelle (Erdungsspannung) verbunden ist, und

einen Bezugsspannungsgenerator (Figur 4), der mit der Steuerelektrode des Stromquelle-Transistors verbunden ist, und der aufweist:

zwei Transistore (40, 41), die das gleiche Typ und die gleichen Eigenschaften wie die Kontrolltransistore haben und als Stromspiegel aufgebaut sind, wobei in dem ersten Transistor (40) seine Steuerelektrode (Basis) und eine erste leitungsfaehige Elektrode (Kollektor) gemeinsan verbunden und ueber einen ersten Widerstand (R40) an die zweite Spannungsquelle (Erdungsspannung) gekoppelt sind, und die zweite leitungsfaehige Elektrode (Emitter) mit der ersten Spannungsquelle (Vc) verbunden ist, und wobei in dem zweiten Transistor (41) seine Steuerelektrode (Basis) mit der Steuerelektrode des ersten Transistors, die erste leitungsfaehige Elektrode (Kollektor) ueber einen zweiten Widerstand (R41) mit der gleichen Groesse wie der erste Widerstand (R40) mit der zweiten Spannungsquelle (Erdungsspannung) und die zweite leitungsfaehige Elektrode (Emitter) mit der ersten Spannungsquelle verbunden ist, und

eine Ausgangsschaltung (43, 44, R43, R44, R45) zur Lieferung der Bezugsspannung (REF) ab der Spannung, die an der ersten leitungsfaehigen Elektrode (Kollektor) des zweiten Transistors (41) vorliegt.

2. Schaltung nach Anspruch 1, dadurch gekennzeichnet, dass die Ausgangsschaltung folgendes aufweist:

einen ersten Transistor (43), in dem seine Steuerelektrode (Basis) mit des ersten leitungsfaehigen Elektrode (Kollektor) in dem zweiten Transistor (41) des Stromspiegels des Stromgenerators, die erste leitungsfaehige Elektrode (Kollektor) ueber einen ersten Widerstand (R45) mit der ersten Spannungsquelle (Vc) und die zweite leitungsfaehige Elektrode (Emitter) ueber einen zweiten Widerstand (R43) mit der zweiten Spannungsquelle (Erdungsspannung) verbunden ist, einen zweiten Transistor (44), in dem seine Steuerelektrode (Basis) mit der ersten leitungsfaehige Elektrode (Kollektor) in dem ersten Transistor (43), seine erste leitungsfaehige Elektrode (Kollektor) mit der ersten Spannungsquelle (Vc) und seine zweite leitungsfaehige Elektrode (Emitter) ueber einen dritten Widerstand (R44) mit der zweiten Spannungsquelle verbunden ist, wobei die Bezugsspannung an die zweite leitungsfaehige Elektrode in dem zweiten Transistor (44) geliefert ist.

3. Schaltung nach Anspruch 2, dadurch gekennzeichnet, dass das Verhaeltnis der Groesse des ersten Widerstands (R45) und der Groesse des zweiten Widerstands (R43) in der Ausgangsschaltung angenaehert 0,8 ist.

4. Schaltung nach Anspruch 1, 2 oder 3, dadurch gekennzeichnet, dass die Treibertransistore das Typ NPN und die Kontroll- und Regeltransistore das Typ PNP haben.

5. Schaltung nach Anspruch 4, dadurch gekennzeichnet, dass die Kollektore der Kontroll- und Regeltransistore mit der ersten Spannungsquelle, die Emitter der Treibertransistore mit den Wortlinien, die Basen dieser Transistore mit den Ausgaengen der Adressdekodier-Schaltung und mit den Kollektoren der Kontrolltransistore verbunden sind.

6. Schaltung nach Anspruch 5, dadurch gekennzeichnet, dass jeder als Stromquelle wirkende Transistor das Typ NPN hat, in dem sein Kollektor mit dem Kollektor des Kontrolltransistors, sein Emitter ueber den Widerstand mit der zweiten Spannungsquelle und seine Basis mit dem Bezugsspannungsgenerator verbunden ist.

7. Schaltung nach Anspruch 5 oder 6, dadurch gekennzeichnet, dass die erste leitungsfaehige Elektrode in dem ersten und zweiten Transistor (40, 41) des Stromspiegels des Spannungsgenerators der Kollektor, die zweite leitungsfaehige Elektrode und der Emitter und die Steuerelektroden die Basen sind.

8. Schaltung nach Anspruch 7, dadurch gekennzeichnet, dass die erste leitungsfaehige Elektrode des ersten und zweiten Transistors (43, 44) in der Ausgangsschaltung der Kollektor ist, die zweite leitungsfaehige Elektrode der Emitter ist und die Steuerelektroden die Basen sind.

**Claims**

1. A decoding and selection circuit (figure 1) for a memory array having a matrix of cells arranged in n rows and m columns wherein the cells of different rows are connected to n word lines, the selection of a word line being controlled by an address decoding circuit receiving at its input a line addressing signal, and having n outputs (S0—S31), each output controlling the state of a line driver transistor (T0 1—T31 1), the n driver transistors being of a first conductivity type (NPN) and having one of their conductive electrodes (the collector) connected to a first supply voltage (Vc), the other conductive electrode (emitter) being connected to a word line (WL) and the control electrode (base) being connected to an output of said decoding circuit, characterized in that it includes:

n control transistors (T0 2—T31 2) having a conductivity (PNP) opposite to that of said driver transistors, each of said control transistors being associated with one of said driver transistors, and having a first conductive electrode (emitter) connected to said supply voltage (Vc) and the second conductive electrode (collector) connected to the control electrode of its associated driver transistor, said control transistors are grouped into k groups of p elements with k.p=m, the control electrodes of the transistors in one group being connected together, means for maintaining a minimum constant current in the control transistors, said means including:

k regulating transistors (T1—T4) of the same type of conductivity (PNP) as the control transistors, each of the regulating transistors mounted in a current mirror with the p control transistors in each of the groups, has its control electrode (base) connected to the control electrodes of the control transistors, a first conductive electrode (emitter) connected to the first supply voltage and the second conductive electrode (collector) connected to the control electrode and to a controllable current source, including, a transistor (T5—T8) having a conductive electrode (collector) connected to the regulating transistor, the other conductive electrode (emitter) being connected, through a resistor, to a second supply voltage (ground), and a reference voltage generator (figure 4) connected to the control electrode of said current source transistor, including:

two transistors (40, 41) of the same type and of the same characteristics as the control transistors and mounted as a current mirror, the first one (40) having its control electrode (base) and a first conductive electrode (collector) connected in common and connected through a first resistor (40) to the second supply voltage (ground), and the second conductive electrode (emitter) connected to the first supply voltage (Vc), and the second one (41) having its control electrode (base) connected to the control electrode of the first one, the first conductive electrode (collector) connected, through a second resistor (R41) of the same value as the first one (R40), to the second supply voltage (ground), and the second conductive electrode (emitter) connected to the first supply voltage, and an output circuit (43, 44, R43, R44, R45) for generating the reference voltage (REF) from the voltage at the first conductive electrode (collector) of said second transistor (41).

2. A circuit as set forth in claim 1, characterized in that the output circuit includes:

a first transistor (43) having its control electrode (base) connected to the first conductive electrode (collector) of the second transistor (41) of the current mirror of the voltage generator, the first conductive electrode (collector) connected, through a first resistor (R45), to the first supply voltage (Vc), and the second conductive electrode (emitter) connected, through a second resistor (R43), to the second supply voltage (ground), a second transistor (44) having its control electrode (base) connected to the first conductive electrode (collector) of the first transistor (43), its first conductive electrode (collector) connected to the first supply voltage (Vc), and its second conductive electrode (emitter) connected, through a third resistor (R44), to the second supply voltage, the reference voltage being generated to the second conductive electrode of said second transistor (44).

3. A circuit as set forth in claim 2, characterized in that the ratio of the first resistance (R45) and the second resistance (R43) of the output circuit, is about 0.8.

4. A circuit as set forth in claim 1, 2 or 3, characterized in that the driver transistors are of the NPN type, and the control and regulating transistors are of the PNP type.

5. A circuit as set forth in claim 4, characterized in that the collectors of the driver transistors and the emitters of the control and regulating transistors are connected to the first supply voltage, the emitters of the driver transistors are connected to the word lines, the bases of said transistors are connected to the outputs of the address decoding circuit and to the collectors of the control transistors.

6. A circuit as set forth in claim 5, characterized in that each current source transistor is a transistor of the NPN type having its collector connected to the collector of the control transistor, its emitter connected, through said resistor, to the second supply voltage, and its base connected to the reference voltage generator.

7. A circuit as set forth in claim 5 or 6, characterized in that the first conductive electrode of the first and second transistors (40, 41) of the current mirror of the voltage generator, is the collector, the second conductive is the emitter, and the control electrodes are the bases.

8. A circuit as set forth in claim 7, characterized in that the first conductive electrode of the first and second transistors (43, 44) of the output circuit is the collector, the second conductive electrode is the emitter, and the control electrodes are the bases.

FIG. 1

# FIG. 2

# FIG. 3

LIGNE DE BITS
GAUCHE

LIGNE DE
BITS DROITE

# FIG. 4